(19) Europäisches Patentamt / European Patent Office / Office européen des brevets

(11) **EP 2 245 677 B1**

(12) **EUROPÄISCHE PATENTSCHRIFT**

(45) Veröffentlichungstag und Bekanntmachung des Hinweises auf die Patenterteilung:
**10.07.2013 Patentblatt 2013/28**

(21) Anmeldenummer: **09779853.2**

(22) Anmeldetag: **19.06.2009**

(51) Int Cl.:
**H01L 35/30** (2006.01)  **H01L 23/38** (2006.01)

(86) Internationale Anmeldenummer:
**PCT/EP2009/057692**

(87) Internationale Veröffentlichungsnummer:
**WO 2010/006876 (21.01.2010 Gazette 2010/03)**

(54) **WÄRMEÜBERTRÄGER FÜR EIN THERMOELEKTRISCHES DÜNNSCHICHTELEMENT**

HEAT EXCHANGER FOR A THERMOELECTRIC THIN LAYER ELEMENT

DISPOSITIF DE TRANSFERT THERMIQUE POUR UN ÉLÉMENT À COUCHE MINCE THERMOÉLECTRIQUE

(84) Benannte Vertragsstaaten:
**AT BE BG CH CY CZ DE DK EE ES FI FR GB GR HR HU IE IS IT LI LT LU LV MC MK MT NL NO PL PT RO SE SI SK TR**

(30) Priorität: **14.07.2008 DE 102008032856**

(43) Veröffentlichungstag der Anmeldung:
**03.11.2010 Patentblatt 2010/44**

(73) Patentinhaber: **O-Flexx Technologies GmbH**
**47059 Duisburg (DE)**

(72) Erfinder:
• **BISGES, Michael**
 **93161 Sinzing (DE)**
• **ULLAND, Holger Albert**
 **47877 Willich (DE)**

(74) Vertreter: **Kohlmann, Kai**
 **Donatusstraße 1**
 **52078 Aachen (DE)**

(56) Entgegenhaltungen:
| | |
|---|---|
| EP-A1- 1 287 566 | DE-A1- 10 122 679 |
| DE-A1-102006 031 164 | US-A- 3 212 275 |
| US-A1- 2003 066 554 | US-A1- 2006 151 021 |
| US-A1- 2007 256 427 | |

**Beschreibung**

Die Erfindung betrifft einen Wärmeüberträger für mindestens ein thermoelektrisches Dünnschichtelement mit einer heißen und einer kalten Seite, die jeweils an gegenüberliegenden Längsseiten des Dünnschichtelementes angeordnet sind, wobei die heiße Seite mit einem Ankopplungselement an eine Wärmequelle und die kalte Seite mit einer Wärmesenke verbunden ist.

Die direkte Wandlung von Wärme in elektrische Energie ist mit einem thermoelektrischen Generator möglich. Man verwendet hierfür vorzugsweise unterschiedlich dotierte Halbleitermaterialien, wodurch sich die Effizienz gegenüber Thermoelementen mit zwei unterschiedlichen und an einem Ende miteinander verbundenen Metallen, wesentlich steigern lässt. Heute verfügbare thermoelektrische Generatoren haben dennoch nur einen verhältnismäßig geringen Wirkungsgrad. Gebräuchliche Halbleitermaterialien sind Bi2Te3, PbTe, SiGe, BiSb oder FeSi2 mit Wirkungsgraden zwischen 3% und 8%. Um ausreichend hohe Spannungen zu erhalten, werden mehrere thermoelektrische Generatoren elektrisch in Reihe geschaltet.

Die Wirkungsweise der thermoelektrischen Generatoren beruht auf dem thermoelektrischen Effekt, nachfolgend als Seebeck-Effekt bezeichnet. Beim Seebeck-Effekt entsteht zwischen zwei Punkten eines elektrischen Leiters bzw. Halbleiters, die eine verschiedene Temperatur haben, eine elektrische Spannung. Die entstehende Spannung ist bestimmt durch:

$$U_{\text{Seebeck}} = \alpha \cdot \Delta T$$

mit

$\Delta T$     Temperaturdifferenz zwischen den Leiter-/ Halbleiterenden bzw. den Kontaktstellen

$\alpha$       Seebeck-Koeffizient oder so genannte "Thermokraft"

Der Seebeck-Koeffizient hat die Dimension einer elektrischen Spannung pro Temperaturdifferenz (V/K). Die entstehende Spannung ist unabhängig von der Umgebungstemperatur und lediglich von der Temperaturdifferenz der Kontaktstellen abhängig. Ein hoher Wirkungsgrad des thermoelektrischen Generators wird in einem Material mit hohem Seebeck-Koeffizient bei gleichzeitig niedrigem spezifischem Widerstand und niedriger Wärmeleitfähigkeit erreicht.

Um den Wirkungsgrad eines thermoelektrischen Generators zu steigern, wird in der EP 1 287 566 B1 bereits ein thermoelektrisches Dünnschichtelement mit mindestens einer n-Schicht und mindestens einer p-Schicht eines dotierten Halbleiters vorgeschlagen, wobei die n- und die p-Schicht unter Ausbildung eines pn-Übergangs angeordnet sind. Die n - und die p-Schicht sind elektrisch selektiv kontaktiert. Parallel zur Grenzschicht zwischen den n- und p-Schichten ist ein Temperaturgradient angelegt. Der pn-Übergang ist im Wesentlichen entlang der gesamten, vorzugsweise längsten Ausdehnung der n-Schicht und der p-Schicht und damit im Wesentlichen entlang deren gesamter Grenzschicht ausgebildet. Durch den Temperaturgradienten entlang der großflächigen pn-Grenzfläche entsteht ein Temperaturunterschied entlang dieses länglich ausgebildeten pn-Übergangs zwischen zwei Enden eines pn-Schichtpakets, der dazu führt, dass der Wirkungsgrad des thermoelektrischen Elementes höher ist als beim Stand der Technik, der keinen Temperaturgradienten entlang und innerhalb des pn-Übergangs aufweist. Die selektive Kontaktierung der n- und p-Schicht erfolgt entweder durch Einlegieren der Kontakte und den damit verbundenen pn-Übergängen oder durch eine direkte Kontaktierung der einzelnen Schichten. Die selektiven Kontakte sind separate, nicht miteinander in leitender Verbindung stehende Kontakte, die an den p- und n-Schichten angeordnet sind.

Aus der DE 10 2006 031 164 ist ein thermoelektrisches Dünnschichtelement mit einer Trägerstruktur bekannt, auf der mehrere Thermoschenkel aus einem ersten leitfähigen Material und mehrere Thermoschenkel aus einem zweiten leitfähigen Material aufgebracht sind, wobei das erste und zweite leitfähige Material eine unterschiedliche Leitfähigkeit aufweisen und die Thermoschenkel derart miteinander elektrisch gekoppelt sind, dass jeweils zwei Thermoschenkel ein Thermopaar bilden, wobei sämtliche Thermoschenkel aus dem ersten und zweiten leitfähigen Material nebeneinander auf der Trägerstruktur angeordnet sind. Die kalte Seite des thermoelektrischen Dünnschichtelementes befindet sich auf einer Seite der elektrisch leitfähigen ersten und zweiten Materialien und die heiße Seite auf der gegenüberliegenden Seite der elektrisch leitfähigen ersten und zweiten Materialien.

Aus der DE 101 22 679 A1 ist schließlich ein thermoelektrisches Dünnschichtelement bekannt, das ein flexibles Substratmaterial aufweist, auf dem Dünnschicht-Thermopaare aufgebracht sind. Die Dünnschicht-Thermopaare werden aus einer Materialkombination von zwei unterschiedlichen Materialien gebildet, wobei das erste und das zweite Material derart eingerichtet und derart miteinander thermisch gekoppelt sind, dass sie zusammen ein Thermopaar bilden. Die beiden Materialien werden auf die flexible Folie aufgedruckt oder mittels üblicher Abscheideverfahren abgeschieden. Es werden nebeneinander angeordnete Streifen beispielsweise aus Nickel als erstem Material und Streifen aus Chrom als zweitem Material gebildet, wobei die Stege und Streifen an ihren Enden jeweils paarweise über eine Kopplungsstruktur aus dem zweiten Material elektrisch miteinander verbunden sind. Durch die gekoppelten Stege und Streifen wird eine Serienschaltung von mehreren Thermopaaren auf einer kleinen Fläche gebildet. Die hohe Anzahl der Dünnschicht-Thermopaare führt zu einer hohen Ausgangsspannung des Thermoelementes. Die elektrischen Kopplungsstrukturen auf der einen Seite des thermoelektrischen Dünnschichtelementes bilden dessen heiße Seite, die Kopplungsstrukturen auf der gegenüberliegenden Seite des thermoelektrischen Dünnschichtelementes bilden dessen kalte Seite aus, wobei die heiße Seite mit einem Ankopplungselement an eine Wärmequelle und die kalte Seite mit einer Wärmesenke verbunden ist.

Ausgehend von diesem Stand der Technik liegt der Erfindung die Aufgabe zu Grunde, einen Wärmeüberträger der eingangs erwähnten Art zu schaffen, der eine einfache und wirksame Verbindung mit dem thermoelektrischen Dünnschichtelement ermöglicht und den Wirkungsgrad des eingesetzten thermoelektrischen Dünnschichtelementes verbessert. Insbesondere soll der Wärmeüberträger auch für die Aufnahme großflächiger, insbesondere flexibler thermoelektrischer Dünnschichtelemente geeignet sein.

Die Lösung dieser Aufgabe basiert auf dem Gedanken, die insbesondere flexiblen Dünnschichtelemente zwischen dem Ankopplungselement und der Wärmesenke des Wärmeüberträgers aufzuspannen und die Lasten zwischen Ankopplungselement und Wärmesenke über eine insbesondere thermisch isolierende Tragstruktur abzutragen.

Im Einzelnen wird die Aufgabe bei einem Wärmeüberträger der eingangs erwähnten Art dadurch gelöst, dass

-    das Ankoppelungselement mindestens zwei Profile mit parallel zueinander angeordneten Außenflächen umfasst, wobei die Außenflächen benachbarter Profile an der heißen Seite des thermoelektrischen Dünnschichtelementes beidseitig anliegen,

-    die Wärmesenke mindestens zwei Profile mit parallel zueinander angeordneten Außenflächen umfasst, wobei die Außenflächen benachbarter Profile an der kalten Seite des thermoelektrischen Dünnschichtelementes beidseitig anliegen,

-    sich die Profile des Ankopplungselementes und die Profile der Wärmesenke paarweise gegenüberliegen,

-    die an dem Dünnschichtelement anliegenden Außenflächen einander paarweise gegenüberliegender Profile des Ankopplungselementes und der Wärmesenke miteinander fluchten, jedoch im Abstand zueinander angeordnet sind und

-    jeweils zwei einander gegenüberliegende Profile des Ankopplungselementes und der Wärmesenke durch eine Tragstruktur miteinander verbunden sind.

Die thermische Entkopplung von Ankopplungselement und Wärmesenke wird vorzugsweise dadurch erreicht, dass das Material der Tragstruktur eine geringere Wärmeleitfähigkeit als das Material der Profile des Ankopplungselementes und der Wärmesenke aufweist. Eine weitere Entkopplung wird dadurch erreicht, dass jeweils zwei einander gegenüberliegende Profile des Ankopplungselementes und der Wärmesenke ausschließlich durch die Tragstruktur miteinander verbunden sind, während die an dem Dünnschichtelement anliegenden Außenflächen der paarweise gegenüberliegenden Profile im Abstand zueinander angeordnet sind.

Die wirksame thermische Entkopplung zwischen Ankopplungselement und Wärmesenke führt zu einer hohen Temperaturdifferenz zwischen der heißen und kalten Seite des Dünnschichtelementes und in Folge dessen zu einem verbesserten Wirkungsgrad.

Der erfindungsgemäße Wärmeüberträger erfordert keinerlei Tragfunktion des Dünnschichtelementes, das in Folge dessen als Folie großflächig zwischen den parallel zueinander angeordneten Außenflächen des Ankopplungselementes und den parallel zueinander angeordneten Außenflächen der Wärmesenke aufgespannt werden kann. Um das thermoelektrische Dünnschichtelement aufzuspannen, ist es an seinen Längsseiten jeweils zwischen den parallel zueinander angeordneten Außenflächen der benachbarten Profile eingeklemmt und/oder verklebt. Der erfindungsgemäße Wärmeüberträger erlaubt daher die Herstellung von thermoelektrischen Anordnungen bei denen das vorzugsweise plattenförmige Ankopplungselement eine Größe von einem oder sogar mehreren Quadratmetern aufweisen kann.

Aufgrund der niedrigen Wärmeleitfähigkeit sowie der Eigenspannungsfreiheit besteht die Tragstruktur vorzugsweise aus einem Schaumstoff, insbesondere aus einem Polymer. Die zellige Struktur verringert die Querschnittsfläche für den Wärmetransport und reduziert dadurch die Wärmeleitfähigkeit der Tragstruktur gegenüber dem zumeist metallischen Ankopplungselement bzw. der Wärmesenke.

Vorzugsweise werden Materialien und Verfahren zur Herstellung eines großporigen Schaumstoffes verwendet, um die Wärmeleitfähigkeit weiter zu reduzieren. Sofern der Schaumstoff ein geschlossenzelliger Schaumstoff ist, lässt sich durch Wahl des zum Aufschäumen verwendeten Treibgases ($N_2/CO_2$) die Wärmeleitfähigkeit nochmals reduzieren.

Eine ausreichende Festigkeit und Stabilität des Wärmeüberträgers wird dadurch gewährleistet, dass die Tragstruktur aus einem Hartschaumstoff, insbesondere einem Pur-Hartschaum besteht.

Die Herstellbarkeit des erfindungsgemäßen Wärmeüberträgers wird insbesondere in Verbindung mit einer Tragstruktur aus Schaumstoff dadurch vereinfacht, dass sowohl die Profile des Ankopplungselementes als auch der Wärmesenke U-Profile mit parallelen Außenflächen der Flansche sind und die Flansche einander gegenüberliegender U-Profile aufeinander zuweisen. Die Herstellung des Wärmeüberträgers kann dann in der Weise erfolgen, dass ein herkömmliches Vierkantprofil mit Pur-Schaum ausgeschäumt wird. Nach dem Aushärten des Schaumstoffs werden an parallelen Seitenwänden des Vierkantprofils sich über dessen gesamte Länge erstreckende Längsschlitze eingebracht, wodurch das Vierkantprofil in zwei U-Profile aufgeteilt wird, wobei die Flansche der derart gebildeten, gegenüberliegenden U-Profile fluchtend aufeinander zuweisen, jedoch durch den Längsschlitz voneinander getrennt sind.

Die mechanische Verbindung zwischen den beiden U-Profilen erfolgt ausschließlich über das in Querschnitt rechteckige Schaumstoff-Profil, das sich vorzugsweise über die gesamte Länge der beiden U-Profile erstreckt. Im Ergebnis füllt diese Tragstruktur die beiden gegenüberliegenden U-Profile des Ankopplungselementes einerseits und der Wärmesenke andererseits nahezu vollständig aus. Mindestens zwei derartig hergestellte Profilanordnungen werden sodann auf einem Gestell, insbesondere einer ebenen Platte, so nah zueinander angeordnet, dass die Außenflächen benachbarter U-Profile an der heißen bzw. kalten Seite des Dünnschichtelementes anliegen.

Der wärmeleitende Querschnitt der Tragstruktur kann dadurch weiter reduziert werden, dass im Bereich der zwischen den Flanschen einander gegenüberliegender U-Profile ausgebildeten Spalten Einschnitte in den Schaumstoff eingebracht werden, wobei sich die Einschnitte vorzugsweise über die gesamte Länge, jedoch unter Belassung eines mittleren Stegs erstrecken. Insbesondere bei der weiter oben erläuterten Herstellung der U-Profile aus einem Vierkantprofil lassen sich die Einschnitte in den Schaumstoff in einem Arbeitsgang mit dem Auftrennen des Vierkantprofils herstellen, in dem der Schneidvorgang bis zu einer gewissen Tiefe in das ausgehärtete Schaumstoffmaterial fortgesetzt wird.

Der wärmeleitende Querschnitt kann alternativ oder zusätzlich dadurch reduziert werden, dass die aus Schaumstoff bestehende Tragstruktur quer zur Längserstreckung der Profile verlaufende Durchgänge aufweist. Die Anzahl und Anordnung der Durchgänge sowie die Ausbildung der ggf. vorhandenen Einschnitte in dem Schaumstoffmaterial ist auf die geforderte Tragfähigkeit der Tragstruktur abzustimmen.

Sofern auf Schaumstoff für die Tragstruktur verzichtet werden soll, ist die Tragstruktur im Bereich der zwischen den Flanschen einander gegenüberliegender U-Profile ausgebildeten Spalten angeordnet und wird insbesondere von mehreren Verbindungsstegen zwischen zwei gegenüberliegenden U-Profilen gebildet. Im Interesse eines geringen Wärmeübergangs wird unter Berücksichtigung der geforderten Tragfähigkeit der Abstand zwischen den Verbindungsstegen maximiert und der Querschnitt der Verbindungsstege minimiert. Vorzugsweise bestehen die Verbindungsstege aus einem gegenüber den U-Profilen geringer wärmeleitfähigen Material. Sie können jedoch auch aus dem Profilmaterial selbst bestehen, wenngleich hierdurch an den Verbindungsstellen unerwünschte Wärmebrücken entstehen, die den Wirkungsgrad des von dem Wärmeüberträger aufgenommenen Dünnschichtelementes bzw. der aufgenommenen Dünnschichtelemente reduziert.

Zur weiteren Verbesserung des Wirkungsgrades durch Aufrechterhaltung einer höheren Temperaturdifferenz zwischen heißer und kalter Seite des Dünnschichtelementes sind an der Wärmesenke Kühlrippen angeordnet. Durch die Kühlrippen werden die Oberfläche der Wärmesenke und damit die Ableitung des Wärmestroms verbessert.

Wie bereits weiter oben erwähnt, weist das Ankopplungselement vorzugsweise ein Gestell auf, an dem die mindestens zwei Profile, vorzugsweise jedoch mehrere Profile angeordnet sind. Zwischen jeweils zwei benachbarten Profilen wird die heiße Seite des Dünnschichtelementes eingeklemmt und/oder verklebt. Sind mehr als zwei U-Profile parallel zueinander auf dem Gestell angeordnet, dienen die von den außen liegenden U-Profilen eingeschlossenen U-Profile zur Halterung von Dünnschichtelementen auf beiden Seiten.

Um eine hohe Wärmeleitfähigkeit und damit gute Ein- bzw. Auskopplung der Wärme zu gewährleisten, bestehen das Ankopplungselement und/oder die Wärmesenke aus Metall oder Keramik bzw. einem gut wärmeleitenden Kunststoff.

Nachfolgend wird die Erfindung anhand der Ausführungsbeispiele näher erläutert. Es zeigen

Figur 1a     eine Seitenansicht einer erfindungsgemäßen thermoelektrischen Anordnung

Figur 1b     einen Schnitt durch die Anordnung nach Figur 1a längs der Linie A-A

Figur 1c     eine vergrößerte Darstellung des Details B nach Figur 1a

Figur 2a     eine Darstellung einer Profilanordnung mit zwei gegenüberliegenden U-Profilen eines Wärmeüberträgers in Vorder- und Seitenansicht mit Tragkörper

Figur 2b     einen Schnitt längs der Linie A-A durch die Profilanordnung nach Figur 2 a

Figur 2c    eine Darstellung einer weiteren Profilanordnung mit zwei gegenüberliegenden U-Profilen eines Wärmeüberträgers in Vorder- und Seitenansicht mit eingeschnittenem Tragkörper

Figur 2d    einen Schnitt längs der Linie A-A durch die Profilanordnung nach Figur 2c

Figur 3a    eine Darstellung einer weiteren Profilanordnung mit zwei gegenüberliegenden U-Profilen eines Wärmeüberträgers in Vorder- und Seitenansicht mit einem Durchgänge aufweisenden Tragkörper

Figur 3b    einen Schnitt längs der Linie A-A durch die Profilanordnung nach Figur 3a

Figur 3c    eine Darstellung einer weiteren Profilanordnung mit zwei gegenüberliegenden U-Profilen eines Wärmeüberträgers in Vorder- und Seitenansicht, wobei die Profile durch Stege miteinander verbunden sind

Figur 3d    einen Schnitt längs der Linie A-A durch die Profilanordnung nach Figur 3c

Figur 4     eine schematische Darstellung einer erfindungsgemäßen thermoelektrischen Anordnung zur Verdeutlichung des Wärmestroms von der heißen zur kalten Seite des Dünnschichtelementes.

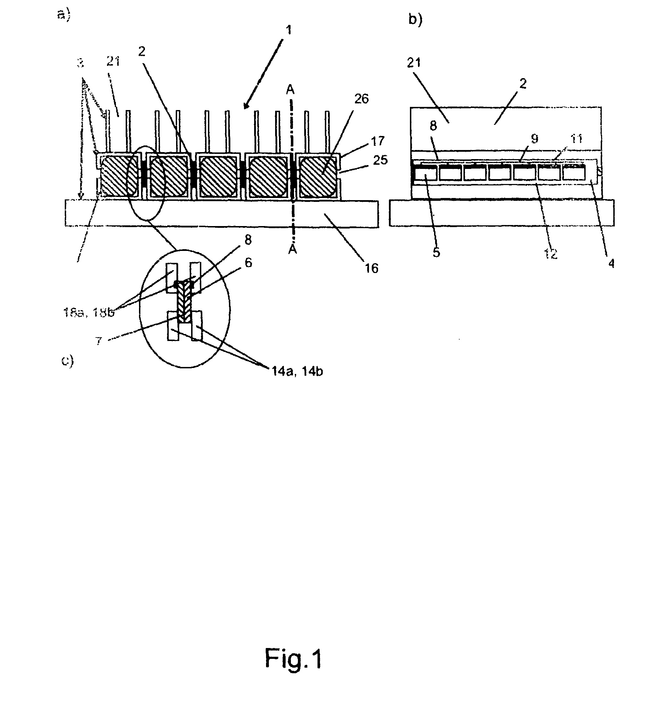

Figur 1 zeigt eine thermoelektrische Anordnung in Form eines thermoelektrischen Generators (1), der im Wesentlichen aus einem Dünnschichtelement (2) und einem Wärmeüberträger (3) besteht. Wie insbesondere aus den Figuren 1b) und 1c) ersichtlich, wird das Dünnschichtelement (2) von einer flexiblen, streifenförmigen Trägerfolie (4) gebildet, auf der mehrere elektrisch miteinander verbundene Abschnitte (5) mit einem ersten und einem zweiten Halbleiter-Material (6, 7) angeordnet sind. Die auf der Trägerfolie (4) in Längsrichtung nebeneinander angeordneten Abschnitte (5) sind wechselweise entweder über das Halbleitermaterial (6) bzw. auf der gegenüberliegenden Seite über das Halbleitermaterial (7) mittels elektrischer Dünnschichtkontakte (8, 9) in Reihe geschaltet. Durch die Reihenschaltung addieren sich die in den einzelnen Abschnitten (5) des Dünnschichtelementes (2) erzeugten Seebeck-Spannungen.

Insgesamt weist der thermoelektrische Generator (1) vier auf Trägerfolien (4) angeordnete Dünnschichtelemente (2) auf, die wiederum sämtlich parallel geschaltet sind.

Am in den Figuren unteren Rand der Trägerfolie (4) befindet sich die kalte Seite (11) und am in den Figuren oberen Rand die heiße Seite (12) des Dünnschichtelementes (2).

Die heiße Seite (12) jedes Dünnschichtelementes (2) ist mit einem Ankopplungselement an eine in den Figuren nicht dargestellte Wärmequelle angebunden. Das Ankopplungselement umfasst in dem dargestellten Ausführungsbeispiel fünf U-Profile (13), deren die seitlichen Flansche (14a, 14b) verbindende Stege (15) auf einer ebenen Platte (16) aufliegen.

Die kalte Seite (11) des Dünnschichtelementes (2) ist mit einer Wärmesenke verbunden, die im dargestellten Ausführungsbeispiel fünf U-Profile (17) mit nach unten weisenden Flanschen (18a, 18b) sowie an den die Flansche (18a, 18b) verbindenden Stegen (19) angeordnete, sich senkrecht nach oben erstreckende Kühlrippen (21) umfasst. Sowohl die Flansche (14a, 14b) der U-Profile (13) des Ankopplungselementes als auch die Flansche (18a, 18b) der U-Profile (17) der Wärmesenke sind mit ihren Außenflächen (22, 23) parallel zu dem jeweils benachbarten U-Profil (13/17) des Ankopplungselementes bzw. der Wärmesenke angeordnet.

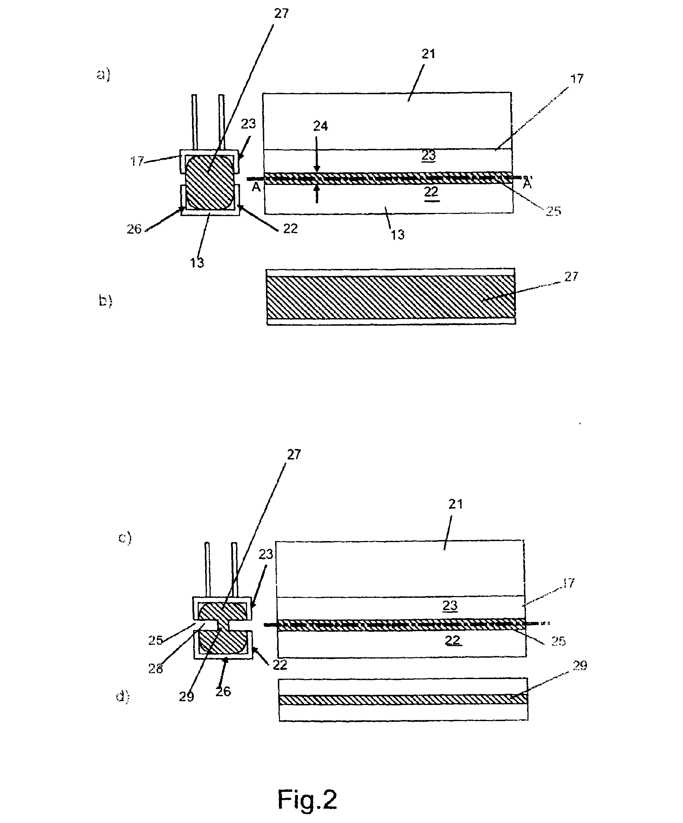

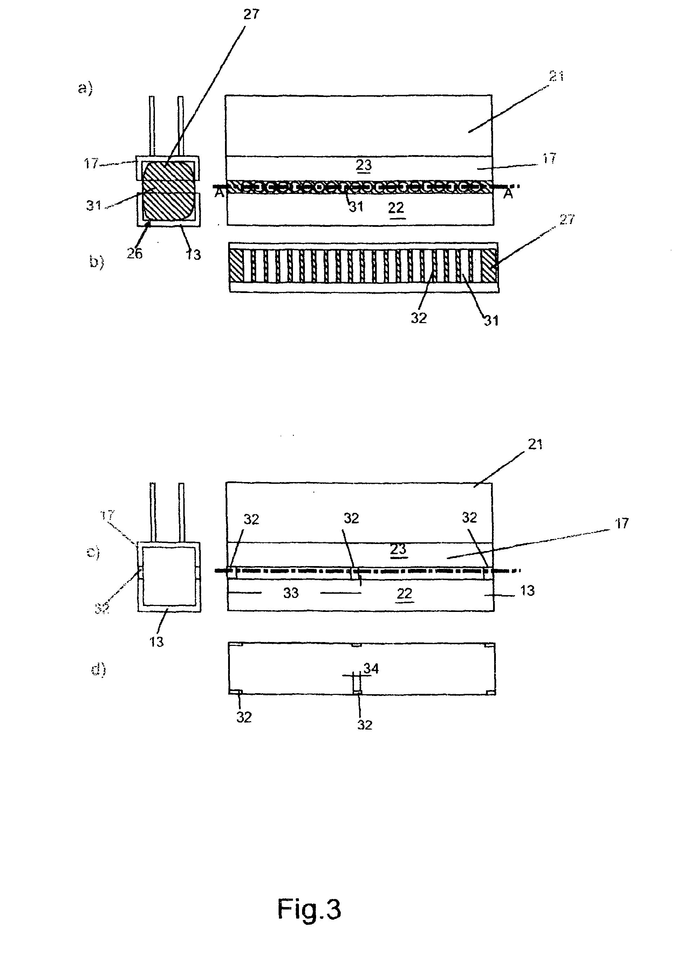

Die Außenflächen (22) jeweils zwei benachbarter U-Profile (13) des Ankopplungselementes liegen beidseitig bündig an der heißen Seite (12) des thermoelektrischen Dünnschichtelementes (2) an. Der Abstand zwischen jeweils zwei benachbarten U-Profilen (13) ist so gewählt, dass die heiße Seite (12) des Dünnschichtelementes (2) zwischen den Außenflächen (22) eingeklemmt wird. Zur zusätzlichen Fixierung kann ein Klebstoff zwischen die Außenflächen (22) und die Oberfläche des Dünnschichtelementes (2) eingebracht werden. Gegenüberliegend zu jedem U-Profil (13) ist jeweils eines der U-Profile (17) der Wärmesenke angeordnet. Die Flansche (14a, 14b) sowie die Flansche (18a, 18b) einander gegenüberliegender U-Profile (13, 17) weisen fluchtend aufeinander zu, sind jedoch im Abstand (24) unter Ausbildung eines insbesondere in den Figuren 2 und 3 erkennbaren Spaltes (25) zueinander angeordnet. Der Abstand zwischen jeweils zwei benachbarten U-Profilen (17) der Wärmesenke ist ebenfalls so gewählt, dass die kalte Seite (12) des Dünnschichtelementes (2) zwischen den Außenflächen (23) eingeklemmt wird. Auch hier kann zusätzlich ein Klebstoff eingebracht werden.

Die unteren U-Profile (13) des Ankopplungselementes sind mit den oberen U-Profilen (17) der Wärmesenke über eine Tragstruktur (26) miteinander verbunden: Im Ausführungsbeispiel nach Figur 1 sind die unteren U-Profile (13) mit den oberen U-Profilen (17) mittels eines Hartschaumstoff-Profils mechanisch miteinander verbunden, das den Zwischenraum zwischen jeweils zwei gegenüberliegenden U-Profilen (13, 17) nahezu vollständig ausfüllt. Wie insbesondere aus Figur 2b erkennbar, erstreckt sich das rechteckige Hartschaumstoff-Profil (27) über die gesamte Länge der U-Profile (13, 17).

Die Spalten (25) zwischen den unteren und oberen U-Profilen (13, 17) unterbinden wirksam einen direkten Wärmefluss zwischen Ankopplungselement und Wärmesenke über die Profile (13, 17), die ausschließlich durch den thermisch isolierenden Hartschaumstoff in Form des Profils (27) mechanisch fest miteinander verbunden sind. Die für die Wärmeleitung aktive Querschnittsfläche wird durch die Verwendung eines großporigen Hartschaumstoffs deutlich reduziert.

Figuren 2c) und 2d) zeigen eine Variation der Tragstruktur (26), die im Bereich der Spalten (25) zwischen den Flanschen (14a, 14b, 18a, 18b) jeweils horizontal verlaufende Einschnitte (28) in dem Hartschaumstoff-Profil (27) aufweist, die bis an einen mittig angeordneten Steg (29) heranreichen. Die Verbindung zwischen den unteren U-Profilen (13) und den oberen U-Profilen (17) erfolgt ausschließlich über die Stege (29), die in der Summe eine ausreichende Stabilität der durch die Hartschaumstoff-Profile (27) gebildeten Tragstruktur (26) gewährleisten.

Figuren 3a) und 3b) zeigen ein Hartschaumstoff-Profil (27) bei dem die von den Hartschaumstoff-Profilen (27) gebildete Tragstruktur (26) durch quer zur Längserstreckung der U-Profile (13, 17) verlaufende hohlzylindrische Durchgänge (31) reduziert wird. Die zwischen benachbarten Durchgängen (31) verbleibenden Stege (32) verleihen der durch die Hartschaumstoff-Profile (27) gebildeten Tragstruktur (26) eine ausreichende Stabilität.

Die Figuren 3c) und 3d) zeigen schließlich eine Tragstruktur (26) zwischen gegenüberliegenden U-Profilen (13, 17) die ohne ein zusätzliches Hartschaumstoff-Profil auskommt. Bei dieser Ausführungsform bilden Verbindungsstege (32) zwischen jeweils zwei gegenüberliegenden U-Profilen (13, 17) die Tragstruktur (26). Aufgrund des großen Abstandes (33) sowie der geringen Breite (34) der Verbindungsstege (32) bilden diese selbst bei Ausbildung der Verbindungsstege aus dem gleichen Material wie die Wärmesenke und das Einkopplungselement keine die Funktion der thermoelektrischen Anordnung in Frage stellenden Wärmebrücken aus. Vorzugsweise werden jedoch die Verbindungsstege (32) aus einem Material mit geringerer Wärmeleitfähigkeit als das Material des Ankopplungselementes und der Wärmesenke hergestellt.

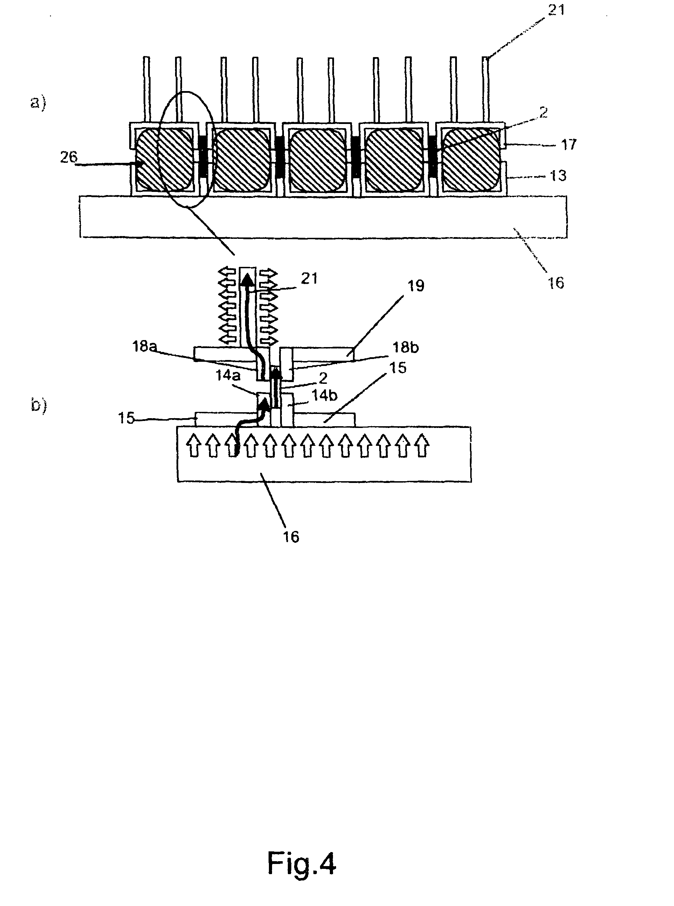

Figur 4) verdeutlicht schließlich, das in der erfindungsgemäßen thermoelektrischen Anordnung die Dünnschichtelemente (2) ausschließlich eine thermische und elektrische Funktion aufweisen, während die tragende Funktion ausschließlich von dem thermisch und elektrisch isolierenden Hartschaumstoff-Profil (27) übernommen wird. Der Wärmestrom fließt von einer nicht dargestellten, an die Platte (16) gekoppelten Wärmequelle über die Platte (16) durch die auf der Platte (16) aufliegenden Stege (15) sowie Flansche (14) der unteren U-Profile (13), die Dünnschichtelemente (2) sowie von der kalten Seite (11) der Dünnschichtelemente (2) über die oberen U-Profile (17) und die an deren Stegen (19) angeordneten Kühlprofile (21), die die Restwärme an die Umgebungsluft abgeben.

Bezugszeichenliste

| Nr. | Bezeichnung | Nr. | Bezeichnung |
|---|---|---|---|
| 1. | thermoelektrischer Generator | 18a, b | Flansche |
| 2. | Dünnschichtelement | 19. | Stege |
| 3. | Wärmeüberträger | 20. | --- |
| 4. | Trägerfolie | 21. | Kühlrippen |
| 5. | Abschnitte | 22. | Außenflächen Ankopplungselement |
| 6. | erstes Halbleitermaterial | 23. | Außenflächen Wärmesenke |
| 7. | zweites Halbleitermaterial | 24. | Abstand |
| 8. | elektrische Dünnschichtkontakte | 25. | Spalten |
| 9. | elektrische Dünnschichtkontakte | 26. | Tragstruktur |
| 10. | --- | 27. | Hartschaumstoff-Profil |
| 11. | kalte Seite | 28. | Einschnitt |
| 12. | heiße Seite | 29. | Steg |
| 13. | U-Profile | 30. | --- |
| 14a,b. | Flansche | 31. | Durchgänge |
| 15. | Stege | 32. | Verbindungssteg |
| 16. | Platte | 33. | Abstand |
| 17. | U-Profile | 34. | Breite |

**Patentansprüche**

1. Wärmeüberträger für mindestens ein thermoelektrisches Dünnschichtelement mit einer heißen und einer kalten Seite, die jeweils an gegenüberliegenden Längsseiten des Dünnschichtelementes angeordnet sind, wobei die heiße Seite mit einem Ankopplungselement an eine Wärmequelle und die kalte Seite mit einer Wärmesenke verbunden ist, **dadurch gekennzeichnet, dass**

   - das Ankoppelungselement mindestens zwei Profile (13) mit parallel zueinander angeordneten Außenflächen (22) umfasst, wobei die Außenflächen (22) benachbarter Profile (13) an der heißen Seite (12) des thermoelektrischen Dünnschichtelementes (2) beidseitig anliegen,
   - die Wärmesenke mindestens zwei Profile (17) mit parallel zueinander angeordneten Außenflächen (23) umfasst, wobei die Außenflächen (23) benachbarter Profile (17) an der kalten Seite (11) des thermoelektrischen Dünnschichtelementes (2) beidseitig anliegen,
   - sich die Profile (13) des Ankopplungselementes und die Profile (17) der Wärmesenke paarweise gegenüberliegen,
   - die an dem Dünnschichtelement (2) anliegenden Außenflächen (22, 23) einander paarweise gegenüberliegender Profile (13, 17) des Ankopplungselementes und der Wärmesenke miteinander fluchten, jedoch im Abstand (24) zueinander angeordnet sind und
   - jeweils zwei einander gegenüberliegende Profile (13, 17) des Ankopplungselementes und der Wärmesenke durch eine Tragstruktur (26) miteinander verbunden sind.

2. Wärmeüberträger nach Anspruch 1, **dadurch gekennzeichnet, dass** sowohl die Profile (13, 17) des Ankopplungselementes als auch der Wärmesenke U-Profile mit parallelen Außenflächen (22, 23) der Flansche (14a, 14b, 18a, 18b) sind und die Flansche(14a, 18a, 14b, 18b) einander gegenüberliegender U-Profile (13, 17) aufeinander zu weisen.

3. Wärmeüberträger nach Anspruch 1 oder 2, **dadurch gekennzeichnet, dass** das Material der Tragstruktur (26) eine geringere Wärmeleitfähigkeit als das Material der Profile (13, 17) des Ankopplungselementes und der Wärmesenke aufweist.

4. Wärmeüberträger nach einem der Ansprüche 1 bis 3, **dadurch gekennzeichnet, dass** die Tragstruktur (26) aus einem Schaumstoff besteht.

5. Wärmeüberträger nach Anspruch 4, **dadurch gekennzeichnet, dass** der Schaumstoff ein geschlossenzelliger Schaumstoff ist.

6. Wärmeüberträger nach Anspruch 4 oder 5, **dadurch gekennzeichnet, dass** die Tragstruktur (26) aus einem Kunststoff-Hartschaumstoff besteht.

7. Wärmeüberträger nach Anspruch 2 und einem der Ansprüche 4 bis 6, **dadurch gekennzeichnet, dass** die Tragstruktur (26) den Zwischenraum zwischen zwei gegenüberliegenden U-Profilen (13, 17) nahezu vollständig ausfüllt.

8. Wärmeüberträger nach Anspruch 2 und einem der Ansprüche 4 bis 6, **dadurch gekennzeichnet, dass** die Tragstruktur (26) im Bereich der zwischen den Flanschen(14a, 18a, 14b, 18b) einander gegenüberliegender U-Profile (13, 17) ausgebildeten Spalten (25) Einschnitte (28) aufweist.

9. Wärmeüberträger nach Anspruch 2 und einem der Ansprüche 4 bis 6, **dadurch gekennzeichnet, dass** die Tragstruktur (26) quer zur Längserstreckung der U-Profile (13, 17) verlaufende Durchgänge (31) aufweist.

10. Wärmeüberträger nach Anspruch 2, **dadurch gekennzeichnet, dass** die Tragstruktur (26) im Bereich der zwischen den Flanschen (14a, 18a, 14b, 18b) einander gegenüberliegender U-Profile (13, 17) ausgebildeten Spalten (25) angeordnet ist.

11. Wärmeüberträger nach Anspruch 10, **dadurch gekennzeichnet, dass** die Tragstruktur von mehreren Verbindungsstegen (32) zwischen zwei gegenüberliegenden U-Profilen (13, 17) gebildet wird.

12. Wärmeüberträger nach einem der Ansprüche 1 bis 11,
    **dadurch gekennzeichnet, dass** an der Wärmesenke Kühlrippen (21) angeordnet sind

**13.** Wärmeüberträger nach einem der Ansprüche 1 bis 12,
**dadurch gekennzeichnet, dass** das Ankopplungselement ein Gestell aufweist, an dem die mindestens zwei Profile (13) angeordnet sind

**14.** Wärmeüberträger nach Anspruch 2 und 13, **dadurch gekennzeichnet, dass** das Gestell als Platte (16) ausgebildet ist, auf deren Oberfläche die die Flansche (14a, 14b) verbindenden Stege (15) der U-Profile (13) aufliegen.

**15.** Wärmeüberträger nach einem der Ansprüche 1 bis 14,
**dadurch gekennzeichnet, dass** das Ankopplungselement und /oder die Wärmesenke aus Metall, Keramik oder Kunststoff bestehen.

**16.** Wärmeüberträger nach einem der Ansprüche 1 bis 15,
**dadurch gekennzeichnet, dass** das thermoelektrische Dünnschichtelement (2) an seinen Längsseiten jeweils zwischen den parallel zueinander angeordneten Außenflächen (22, 23) benachbarter Profile (13, 17) eingeklemmt ist.

**17.** Wärmeüberträger nach einem der Ansprüche 1 bis 16,
**dadurch gekennzeichnet, dass** das thermoelektrische Dünnschichtelement (2) an seinen Längsseiten jeweils mit den parallel zueinander angeordneten Außenflächen (22, 23) benachbarter Profile (13, 17) verklebt ist.

**18.** Thermoelektrische Anordnung mit mindestens einem Dünnschichtelement (2) sowie einem Wärmeüberträger (3) nach einem der Ansprüche 1 bis 17.


**Claims**

**1.** A heat exchanger for at least one thermoelectric thin film element having a hot and a cold side, which are each disposed on opposite longitudinal sides of the thin film element, wherein the hot side is connected by means of a connecting element to a heat source and the cold side is connected to a heat sink, **characterized in that**

- the connecting element comprises at least two profiles (13) having outer surfaces (22) arranged parallel to one another, wherein the outer surfaces (22) of adjacent profiles (13) abut against the hot side (12) of the thermoelectric thin-film element (2) on both sides,
- the heat sink comprises at least two profiles (17) having outer surfaces (23) arranged parallel to one another, wherein the outer surfaces (23) of adjacent profiles (17) abut against the cold side (11) of the thermoelectric thin-film element (2) on both sides,
- the profiles (13) of the connecting element and the profiles (17) of the heat sink lie opposite one another in pairs,
- the outer surfaces (22, 23), which abut against the thin film element (2), of the opposing pairs of profiles (13, 17) of the connecting element and the heat sink are aligned with one another but disposed at a distance (24) from one another and
- respectively two opposing profiles (13, 17) of the connecting element and the heat sink are connected to one another by a support structure (26).

**2.** The heat exchanger according to claim 1, **characterized in that** both the profiles (13, 17) of the connecting element and also of the heat sink are U profiles having parallel outer surfaces (22, 23) of the flanges (14a, 14b, 18a, 18b) and the flanges (14a, 18a, 14b, 18b) of opposing U profiles (13, 17) point towards one another.

**3.** The heat exchanger according to claim 1 or 2, **characterized in that** the material of the support structure (26) has a lower thermal conductivity than the material of the profiles (13, 17) of the connecting element and the heat sink.

**4.** The heat exchanger according to any one of claims 1 to 3, **characterized in that** the support structure (26) consists of a foam.

**5.** The heat exchanger according to claim 4, **characterized in that** the foam is a closed-cell foam.

**6.** The heat exchanger according to claim 4 and 5, **characterized in that** the support structure (26) consists of a plastic hard foam.

**7.** The heat exchanger according to claim 2 and one of claims 4 to 6, **characterized in that** the support structure (26) almost completely fills the intermediate space between two opposing U-profiles (13, 17).

8. The heat exchanger according to claim 2 and one of claims 4 to 6, **characterized in that** the support structure (26) comprises notches (28) in the region of the gaps (25) formed between the flanges (14a, 18a, 14b, 18b) of opposing U profiles (13, 17).

9. The heat exchanger according to claim 2 and one of claims 4 to 6, **characterized in that** the support structure (26) comprises passages (31) running transversely to the longitudinal extension of the U-profiles (13, 17).

10. The heat exchanger according to claim 2, **characterized in that** the support structure (26) is disposed in the region of the gaps (25) formed between the flanges (14a, 18a, 14b, 18b) of opposing U-profiles (13, 17).

11. The heat exchanger according to claim 10, **characterized in that** the support structure (26) is formed by a plurality of connecting webs (32) between two opposing U profiles (13, 17).

12. The heat exchanger according to any one of claims 1 to 11, **characterized in that** cooling fins (21) are disposed on the heat sink.

13. The heat exchanger according to any one of claims 1 to 12, **characterized in that** the connecting element comprises a frame on which the at least two profiles (13) are disposed.

14. The heat exchanger according to claim 2 and 13, **characterized in that** the frame is configured as a plate (16) on the surface whereof the webs (15) of the U profiles (13) connecting the flanges (14a, 14b) rest.

15. The heat exchanger according to any one of claims 1 to 14, **characterized in that** the connecting element and/or the heat sink consist of metal, ceramic or plastic.

16. The heat exchanger according to any one of claims 1 to 15, **characterized in that** the thermoelectric thin-film element (2) is clamped at the longitudinal sides thereof between the outer surfaces (22, 23) of adjacent profiles (13, 17) arranged parallel to one another.

17. The heat exchanger according to any one of claims 1 to 16, **characterized in that** the thermoelectric thin-film element (2) is adhesively bonded at the longitudinal sides thereof with the outer surfaces (22, 23) of adjacent profiles (13, 17) arranged parallel to one another.

18. Thermoelectric arrangement comprising at least one thin-film element (2) and a heat exchanger (3) according to one of claims 1 to 17.

**Revendications**

1. Echangeur thermique pour au moins un élément thermoélectrique à couches minces, avec un côté chaud et un côté froid, qui sont disposés chacun sur des côtés longitudinaux opposés de l'élément à couches minces, le côté chaud étant relié par un élément de couplage à une source de chaleur et le côté froid étant relié à un dissipateur thermique, **caractérisé en ce que**

- l'élément de couplage comprend au moins deux profilés (13) avec des surfaces extérieures (22) disposées à la parallèle les unes des autres, les surfaces extérieures (22) de profilés (13) voisins étant adjacentes de part et d'autre au côté chaud (12) de l'élément thermoélectrique à couches minces (2),
- le dissipateur thermique comprend au moins deux profilés (17) avec des surfaces extérieures (23) disposées à la parallèle les unes des autres, les surfaces extérieures (23) de profilés (17) voisins étant adjacentes de part et d'autre au côté froid (11) de l'élément thermoélectrique à couches minces (2),
- les profilés (13) de l'élément de couplage et les profilés (17) du dissipateur thermique sont opposés par paires,
- les surfaces extérieures (22, 23) adjacentes à l'élément à couches minces (2) de profilés (13, 17) opposés par paires de l'élément de couplage et du dissipateur thermique sont alignées les uns sur les autres, mais sont toutefois disposées avec un écart (24) mutuel et
- chaque fois deux profilés (13, 17) mutuellement opposés de l'élément de couplage et du dissipateur thermique sont reliés ensemble par une structure porteuse (26).

**2.** Echangeur thermique selon la revendication 1, **caractérisé en ce que** qu'aussi bien les profilés (13, 17) de l'élément de couplage que ceux du dissipateur thermique sont des profilés en U avec des surfaces extérieures (22, 23) parallèles des brides (14a, 14b, 18a, 18b) et **en ce que** les brides (14a, 14b, 18a, 18b) de profilés en U (13, 17) mutuellement opposés sont dirigées les unes vers les autres.

**3.** Echangeur thermique selon la revendication 1 ou la revendication 2, **caractérisé en ce que** la matière de la structure porteuse (26) fait preuve d'une thermoconductibilité plus faible que la matière des profilés (13, 17) de l'élément de couplage et du dissipateur thermique.

**4.** Echangeur thermique selon l'une quelconque des revendications 1 à 3, **caractérisé en ce que** la structure porteuse (26) est constituée d'une mousse synthétique.

**5.** Echangeur thermique selon la revendication 4, **caractérisée en ce que** la mousse synthétique est une mousse à alvéoles fermées.

**6.** Echangeur thermique selon la revendication 4 ou la revendication 5, **caractérisée en ce que** la structure porteuse (26) est constituée d'une mousse rigide en matière plastique.

**7.** Echangeur thermique selon la revendication 2 et l'une quelconque des revendications 4 à 6, **caractérisé en ce que** la structure porteuse (26) remplit presque totalement l'intervalle entre deux profilés en U (13, 17) opposés.

**8.** Echangeur thermique selon la revendication 2 et l'une quelconque des revendications 4 à 6, **caractérisé en ce que** la structure porteuse (26) comporte des entailles (28) dans la zone des fentes (25) conçues entre les profilés en U (13, 17) mutuellement opposés entre les brides (14a, 14b, 18a, 18b).

**9.** Echangeur thermique selon la revendication 2 et l'une quelconque des revendications 4 à 6, **caractérisé en ce que** la structure porteuse (26) comporte des passages (31) s'étendant à la transversale de l'extension longitudinale des profilés en U (13, 17).

**10.** Echangeur thermique selon la revendication 2, **caractérisé en ce que** la structure porteuse (26) est disposée dans la zone des fentes (25) conçues entre les profilés en U (13, 17) mutuellement opposés entre les brides (14a, 14b, 18a, 18b).

**11.** Echangeur thermique selon la revendication 10, **caractérisé en ce que** la structure porteuse est formée par plusieurs barrettes de liaison (32) entre deux profilés en U (13, 17) opposés.

**12.** Echangeur thermique selon l'une quelconque des revendications 1 à 11, **caractérisé en ce que** sur le dissipateur thermique sont disposées des nervures de refroidissement (21).

**13.** Echangeur thermique selon l'une quelconque des revendications 1 à 12, **caractérisé en ce que** l'élément de couplage comporte un bâti sur lequel sont disposés au moins deux profilés (13).

**14.** Echangeur thermique selon la revendication 2 et la revendication 13, **caractérisé en ce que** le bâti est conçu en tant que plaque (16), sur la surface de laquelle s'appuient les barrettes (15) des profilés en U (13) reliant les brides (14a, 14b).

**15.** Echangeur thermique selon l'une quelconque des revendications 1 à 14, **caractérisé en ce que** l'élément de couplage et /ou le dissipateur thermique sont constitués en métal, en céramique ou en matière plastique.

**16.** Echangeur thermique selon l'une quelconque des revendications 1 à 15, **caractérisé en ce que** sur ses côtés longitudinaux, l'élément thermoélectrique à couches minces (2) est respectivement coincé entre les surfaces extérieures (22, 23) disposées à la parallèle les unes des autres de profilés (13, 17) voisins.

**17.** Echangeur thermique selon l'une quelconque des revendications 1 à 16, **caractérisé en ce que** par ses côtés longitudinaux, l'élément thermoélectrique à couches minces (2) est respectivement collé sur les surfaces extérieures (22, 23) disposées à la parallèle les unes des autres de profilés (13, 17) voisins.

**18.** Dispositif thermoélectrique avec au moins un élément à couches minces (2), ainsi qu'un échangeur thermique (3) selon l'une quelconque des revendications 1 à 17.

a)

b)

# Fig.1

Fig.2

Fig.3

Fig.4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1287566 B1
- DE 102006031164
- DE 10122679 A1